# EUROPÄISCHE PATENTSCHRIFT

(11) **EP 0 771 077 B1**
(45) Veröffentlichungstag und Bekanntmachung des Hinweises auf die Patenterteilung: **28.07.2004**
(21) Anmeldenummer: 96117194.9
(22) Anmeldetag: 25.10.1996
(51) Int. Cl.: H03M 1/34

(54) **Paralleler Analog-Digital-Umsetzer mit Schwellenwertspannungs-Einstellung**
Parallel analogue-to-digital converter with threshold voltage adjustment
Convertisseur analogique-numérique parallèle à ajustement de tension de seuil

(30) Priorität: 27.10.1995 DE 19540153
(43) Veröffentlichungstag der Anmeldung: 02.05.1997
(73) Patentinhaber: Fraunhofer-Gesellschaft zur Förderung der angewandten Forschung e.V., 80686 München (DE)
(72) Erfinder: Staudt-Fischbach, Peter, 25582 Hohenaspe (DE); Quenzer, Hans Joachim, 25524 Itzehoe (DE); Eichholz, Jörg, 25560 Warringholz (DE)
(74) Vertreter: Leonhard, Frank Reimund, Dipl.-Ing.

(56) Entgegenhaltungen:
- DE-A- 3 402 653
- US-A- 4 420 743
- US-A- 5 237 326
- WALDEN R H ET AL: "A DEEP-SUBMICROMETER ANALOG-TO-DIGITAL CONVERTER USING FOCUSED-ION-BEAM IMPLANTS" IEEE JOURNAL OF SOLID-STATE CIRCUITS, Bd. 25, Nr. 2, 1.April 1990, Seiten 562-571, XP000116702
- A. SILBURT ET AL.: "A Novel Multiple Threshold MOSFET Structure for A/D and D/A Conversion" IEEE JOURNAL OF SOLID-STATE CIRCUITS, Bd. SC-19, Nr. 5, Oktober 1984, NEW YORK US, Seiten 794-802, XP002059891

## Beschreibung

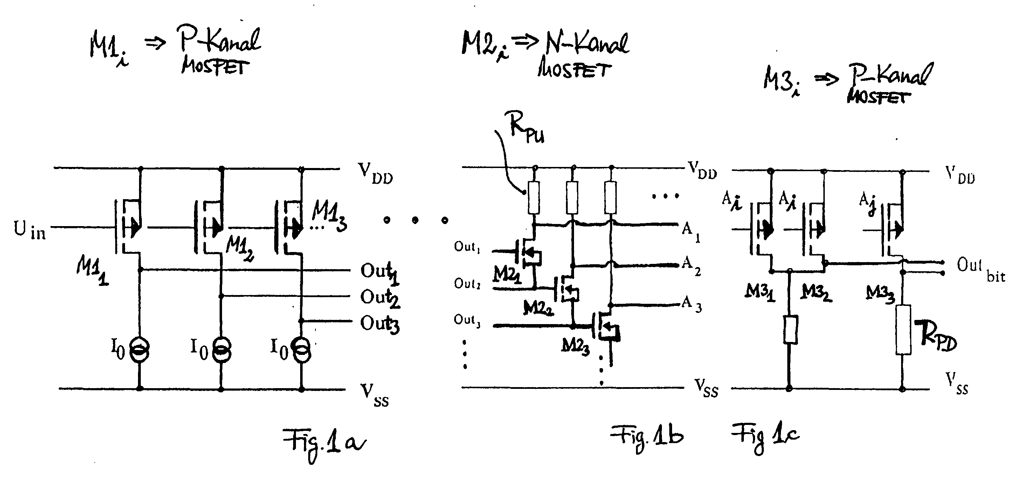

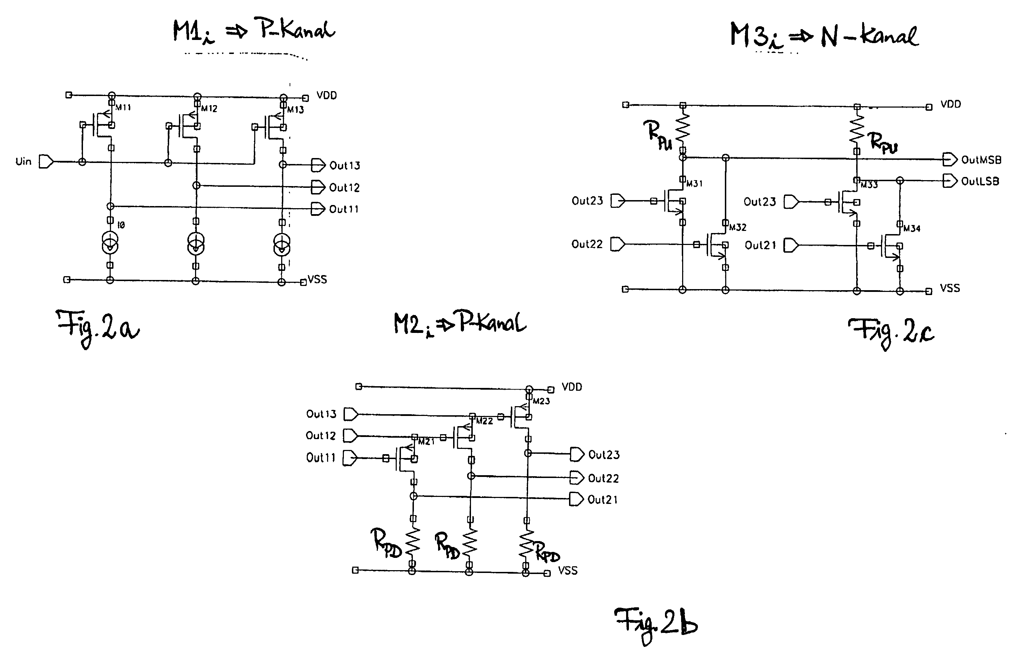

In der **DE-A 34 02 653** (Siemens) ist zur Herstellung mikroelektronischer Bauelemente ein Verfahren zur Erzeugung dotierter Bereiche in Halbleitermaterial mittels Ionenimplantation beschrieben. Bei diesem Verfahren wird auf ein Halbleitersubstrat eine Masken- oder Resistschicht aufgebracht und das Halbleitersubstrat anschließend zusammen mit der Resistschicht aus SiO₂ oder Siliziumnitrid unter Anwendung eines geeigneten "laser-chemischen Ätzverfahrens" durch optische Abbildung der Schwärzungsstruktur einer Photomaske auf die Deckschicht geätzt (dort Figuren 2,3,4). Die Photomaske erzeugt hierbei eine Intensitätsverteilung der Strahlung auf der Oberfläche der Resistschicht, die unter gleichzeitiger Einwirkung des Ätzvorgangs (dort Wanne 26, Ätzflüssigkeit 27) eine Resistschicht mit zweidimensionalem Dickenrelief auf dem Halbleitersubstrat ausbildet. In einem nachfolgenden Implantationsschritt (dort Figur 1) erzeugt eine gleichmäßig verteilte Implantationsstrahlung eine in Tiefenrichtung des Halbleitersubstrats dringende Dotierung des Halbleitersubstrats **mit einem Dotierungsgradienten** entsprechend dem Verlauf des Dickenprofils der Resistschicht. Mit dieser Technik sind Halbleiter der Mikroelektronic und Leistunghalbleiter herstellbar, bevorzugt aber optoelektrische Bauteile. AD-Wandler (also analoge Technik) werden nicht angesprochen.

Aus der **US-A-5,237,326** (Jeong) ist ein Flash-AD-Wandler dem Fachmann zugänglich. Dieser AD-Wandler weist eine Reihe von Komparatoren auf, die in einem VLSI-Prozess entstanden sind. Ihre unterschiedlichen Schwellenspannungen erlauben das Einstellen des Komparators zur Schaffung eines vollen Parallelbetriebes. Das Herstellverfahren zur Herstellung der unterschiedlichen Schwellenspannungen ist durch Anpassung der geometrischen Werte der Kanäle der dort verwendeten Transistoren vorgenommen, vgl. dort Spalte 2, insbesondere Zeilen 30 bis 38 und Zeilen 48 bis 57. Ein anderes Herstellverfahren zeigt die Veröffentlichung **Walden et al.**, "A Deep-Submicrometer Analog-to-Digital Converter Using Focused-Ion-Beam Implants", **Solid State Circuits**, Band 25, Nr. 2, April 1990, Seiten 562 bis 571. Die fokussierte Ionenstrahlung wird dort verwendet, um unterschiedliche Schwellenwerte bei Komparatoren einzustellen und einen Flash-AD-Wandler zu erzeugen. Der AD-Wandler gemäß dortiger Darstellung wird in CMOS/SOS-Technik hergestellt. Die Implantierung geschieht durch einen FIB, vgl. dort Seite 1, linke Spalte, unter "Introduction".Erzielt wurden 32 unterschiedliche Schwellenwerte, vgl. dort Ziffer VI unter "Conclusion", Seite 569. Es konnte vermieden werden, eine Widerstandsleiter einzusetzen.

In einem parallelen Analog-Digital-Umsetzer (AD-Umsetzer) nach dem Stand der Technik wird eine analoge Eingangsspannung über eine Vielzahl von Komparatoren mit einer entsprechenden Anzahl von Referenzspannungen verglichen. Hierbei ist die Anzahl der für den Vergleich der Eingangsspannung mit den Referenzspannungen benötigten Komparatoren eine Funktion der Auflösung des Eingangssignal-Meßbereichs. Für eine Auflösung von n bit werden 2ⁿ-1 Komparatoren benötigt; die dementsprechend im Umsetzer eine dementsprechend große Chipfläche erfordern. In der Praxis kann daher bei gegebener Chipfläche lediglich eine begrenzte Zahl von Komparatoren bereitgestellt werden, so daß dies zu einer Begrenzung der Auflösung und Leistungsfähigkeit des Analog-Digital-Umsetzers oder zu einer abhängig von der Auflösung des Analog-Digital-Umsetzers unerwünscht großen Chipfläche und Bauelementgröße führt.

Infolgedessen führt dies in Anwendungsbereichen, in welchen eine große Zahl von Informationen gleichzeitig aufbereitet werden müssen, zu Nachteilen, da entweder auf dem zur Verfügung stehenden Raum die benötigte Leistungsfähigkeit nicht bereitgestellt werden kann, oder die aus einer hinreichenden Leistungsfähigkeit resultierende Baugröße des Analog-Digital-Umsetzers dessen Einsatz in raum- oder flächenkritischen Anwendungen verhindert.

Der Erfindung liegt daher **die Aufgabe zugrunde**, einen parallelen Analog-Digital-Umsetzer zu schaffen (auch: Herzustellen), der eine erhöhte Leistungsfähigkeit bei gleichzeitig reduziertem Raum- und/oder Flächenbedarf bereitstellt.

Diese Aufgabe wird erfindungsgemäß gelöst (Anspruch 1), durch einen Analog-Digital-Umsetzer mit einer ersten Stufe mit zumindest einem ersten - vorzugsweise mehreren - Transistor(en), dem an seinem Steueranschluß ein analoges Eingangssignal zugeführt wird und der in Abhängigkeit von der Größe des Analogsignals am Ausgang der ersten Stufe ein erstes digitales Ausgangssignal abgibt. Die zwei oder mehr Transistoren der ersten Stufe haben unterschiedliche Dotierungsintensitäten in ihrem Kanal (N-Kanal, P-Kanal), die bei der Herstellung gleichzeitig (in einem Schritt) implantiert werden. Dadurch ergeben sich unterschiedliche Schwellspannungen U_{T}, die zur Ausbildung unterschiedlicher Ansprechschwellen der Transistoren führen, um die A/D-Sofortwandlung durch Eingliedern des Eingangssignals Uᵢₙ in eine Schwellspannungsskaskade der zwei oder mehreren Eingangstransistoren zu erreichen.

Eine zweite Stufe mit mindestens einem zweiten Transistor ist vorgesehen, der an seinem Steueranschluß das digitale Ausgangssignal der ersten Stufe als erstes digitales Eingangssignal empfängt, wobei in Abhängigkeit von der Größe dieses ersten Eingangssignals am Ausgang der zweiten Stufe ein zweites digitales Ausgangssignal abgebbar ist. Eine dritte Stufe schließt sich an mit mindestens einem dritten Transistor, der an seinem Steueranschluß das zweite digitale Ausgangssignal als zweites digitales Eingangssignal empfängt, wobei in Abhängigkeit von der Größe dieses zweiten Eingangssignals am Ausgang der dritten Stufe ein dem analogen Eingangssignal im wesentlichen entsprechendes digitales Mehrbit-Ausgangssignal abgebbar ist.

Das erfindungsgemäße Verfahren (Anspruch 10) zur Herstellung eines Analog-Digital-Umsetzers zum parallelen Umsetzen eines analogen Eingangssignals in ein digitales Ausgangssignal ist gekennzeichnet durch die Schritte des Aufbringens einer Photoresistschicht auf die Oberfläche eines Halbleitersubstrats, des Belichtens der Photoresistschicht mit einem Strahlungs-Intensitätsprofil entsprechend einer vorbestimmten Bildpunkt-Rasterung einer optischen Grautonlithographie-Photomaske, des Erzeugens eines Resistreliefs in der Photoresistschicht auf der Oberfläche des Halbleitersubstrats, durch Entwickeln und Ätzen der belichteten Photoresistschicht, und des Implantierens von Dotierungsstoffen durch das Resistrelief hindurch in das Halbleitersubstrat. Das "Resistrelief" ist dabei so gestaltet, daß unterschiedliche Stufen (Höhen oder Dicken) des Resists jeweils dem lokalen Ort zugeordnet sind an dem ein Kanal eines MOS-Eingangstransistors der ersten Stufe (der A/D-Wandlerstufe) vorgesehen ist. Unterschiedliche Stufenhöhen im Resist führen zu unterschiedlichen Implantationsdosen im Kanal (Variation der Kanalimplantation) bei der gleichmäßigen Bestrahlung mit Ionen während der einen Implantation und damit zum Entstehen von unterschiedlich einstellbaren Schwellspannungen U_{T1}, U_{T2}, U_{T3}... der AD-wandelnden Transistoren.

Der erfindungsgemäße Analog-Digital-Umsetzer führt die Umsetzung des analogen Eingangssignals in mehreren Transistoren der ersten Umsetzerstufe durch. Die Transistoren benötigen nur eine vergleichsweise kleine Halbleiter-Substratfläche und ersetzen in der Summe die in konventioneller Bauweise erforderlichen und eine verhältnismäßig große Substratfläche benötigenden Eingangs-Komparatoren, die entfallen, so daß die Herstellung kompakter und leistungsfähiger paralleler Direkt-Umsetzerschaltungen möglich wird.

Vorteilhaft kann so entweder eine hohe Zahl von Umsetzerelementen auf einer gegebenen Chipfläche untergebracht werden, so daß der resultierende Analog-Digital-Umsetzer unter vorgegebenen Bedingungen eine größtmögliche Auflösung und Leistungsfähigkeit bietet, oder eine geforderte Leistungs-fähigkeit bzw. ein gefordertes Auflösungsvermögen auf beträchtlich verkleinerter Chipfläche bereitgestellt werden. Hierdurch kann der Analog-Digital-Umsetzer sowohl kostengünstig hergestellt als auch in einem breiten, die gleichzeitige Aufbereitung einer großen Zahl von Informationen erfordernden Anwendungsfeld eingesetzt werden (Direktumsetzer bzw. "Flash"-Wandler).

Ein Analog-Digital-Umsetzer nach Anspruch 2 erlaubt es, zur Erzeugung digitaler Zustände MOS-Feldeffekttransistoren als Schalter mit einer von der Transistor-Schwellenspannung U_{T} abhängigen Schaltschwelle einzusetzen.

Die Wahl von Enhancement Mode MOS-Feldeffekttransistoren (Anspruch 3) ermöglicht durch den selbsttätigen Aus-Zustand dieser Transistoren bei unterhalb der Schwellenspannung U_{T} liegenden Eingangssignalen eine weiter vereinfachte Schaltungsanordnung.

Eine gemäß den Ansprüchen 4, 5 oder 6 ausgebildete Eingangsstufe (erste Stufe des Analog-Digital-Umsetzers) erlaubt auf einfache Weise, die Schaltschwelle U_{T} eines als Komparator arbeitenden Inverters in weiten Bereichen nahezu beliebig zu variieren.

Entsprechend Anspruch 7 kann die Zahl der verfügbaren Umsetzerstufen auf einfache Weise vorbestimmt werden. Gemäß den Ansprüchen 8 und 9 wird erreicht, daß die der Eingangsstufe nachgeschalteten Digitalisierungsstufen durch einfache Anordnung gleichartiger mikroelektronischer Bauelemente ausgebildet werden können, so daß eine Herstellung des gesamten Analog-Digital-Umsetzers mit einer geringeren Zahl von Produktionsschritten möglich wird.

Gemäß Ansprüchen 11 und 12 können die Schwellenspannungen U_{T} von flächig über das Halbleitersubstrat verteilt angeordneten Transistoren in nur einem Lithographie- und Implantationsschritt eingestellt werden.

Die Erfindung wird anhand eines Ausführungsbeispiels unter Bezugnahme auf die beigefügte Zeichnung näher beschrieben.
- **Figuren 1 (a) bis (c)**: zeigen vereinfacht eine erste, eine zweite und eine dritte Stufe eines erfindungsgemäßen Analog-Digital-Umsetzers zum **parallelen** Umsetzen eines analogen Eingangssignals Uᵢₙ in ein digitales Ausgangssignal Out_{bit}.
- **Figuren 2 (a) bis (c)**: zeigen einen alternativen Aufbau eines 2-Bit-AD-Wandlers.

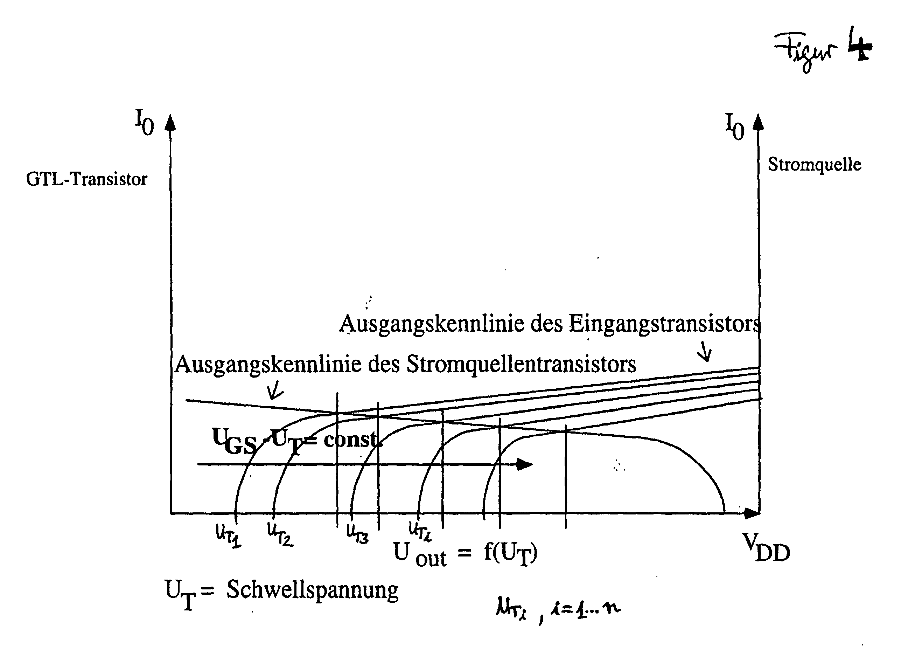

- **Figuren 3 (a) bis (e)**: zeigen abstrahiert ein Verfahren zur Belichtung einer auf ein Halbleitersubstrat 10 aufgebrachten Photoresistschicht 20 mittels der Grauton-Photolithographie und zur Erzeugung eines "Implantationsreliefs" 21 auf dem Halbleitersubstrat 10, wobei die verschiedenen Reliefstufen im tatsächlichen Prozess der AD-Wandler-Herstellung nicht nebeneinander, sondern jeweils einem Kanal K₁,K₂,Kᵢ eines der Eingangstransistoren M1₁,M1₂,M1₃ ... M1ᵢ zugeordnet sind. Die Darstellung der Figur 4 soll den Unterschied der Stufenhöhen im Relief verdeutlichen, der zu unterschiedlichen Implantationsdosen in den jeweiligen Kanälen führt.
- **Figur 4**: zeigt den Verlauf der Ausgangsspannung eines von der ersten Stufe nach Fig. 1 (a) oder Fig. 2 (a) umfaßten Inverters als Funktion der verschieden gewählten Schwellenspannung U_{T1},U_{T2},U_{T3} ... U_{Ti}.
- **Figur 5**: ist ein - an sich bekannter - Aufbau eines MOS-Transistors mit Kanal K.

Für je eine Digitalisierungseinheit des parallelen Analog-Digital-Umsetzers ist **in Fig. 1 (a) bis (c)** ein MOS-Feldeffekttransistor (MOSFET), bevorzugt ein Enhancement Mode MOSFET, vorgesehen. Eine der Zahl der vorgesehenen Umsetzerstufen entsprechende Anzahl von MOSFETs wird parallel geschaltet und zum Erhalt einer vollständigen Parallel-Umsetzung in einem Schritt (Flash-Wandlung) mit einem 1-aus-n-Encoder gekoppelt (sogenannter Prioritäts-Dekoder).

Die Einstellung der Schwellenspannungen U_{Ti} der MOSFETs auf geeignete Werte erfolgt hierbei durch Dotierung des MOSFET-Kanalbereichs unter Anwendung der Grautonlithographie und nachfolgender Ionenimplantation entsprechend des erzeugten (lokal verteilten) Resistreliefs, d.h. durch Variation der Implantationsdosen der Implantat-Ionen im Kanalbereich (für oberflächenleitende MOSFETs) und/oder durch Wannenimplantation.

Um eine große Anzahl unterschiedlicher Implantationsschritten zu vermeiden, die je nach der Anzahl der Implantationsebenen das zweifache der Auflösung des Analog-Digital-Umsetzers erreichen kann, wird die Oberflächenkonzentration im Kanalbereich durch Implantation durch eine Graustufen-Lackmaske mit einer Implantations-Transparenz zwischen oberhalb 0% und unter 100% eingestellt. Dazu wird als Grautonlithographie-Photomaske eine Maske verwendet, deren Bildpunkt-Rasterung eine Transparenz für die Implantation zwischen 0% und 100% aufweist. Der Implantationsschritt zur Einstellung der Schwellenspannung U_{T} von in dem Halbleitersubstrat angeordneten MOS-Feldeffekttransistoren bildet sodann die jeweiligen Oberflächenkonzentrationen der Kanalbereiche der MOS-Feldeffekttransistoren in Übereinstimmung mit einer jeweiligen örtlichen Transparenz (der jeweils örtlich gesteuert vorgegebenen Durchlässigkeit) der Grautonlithographie-Photomaske.

Auf diese Weise wird mit lediglich einem Lithographieschritt und lediglich einem Implantationsschritt eine Vielzahl von unterschiedlichen Schwellenspannungen U_{T1},U_{T2},U_{T3} ... U_{Ti} simultan eingestellt.

**Fig. 1 (a)** zeigt für einen Zwei-Bit-Wandler als Eingangsstufe beispielhaft drei in Parallelschaltung angeordnete Eingangstransistoren bildende P-Kanal MOS-Feldeffekttransistoren (MOSFETs) M1₁, M1₂ und M1₃, deren Source-Anschlüsse mit einer ersten Spannung V_{DD} und deren Drain-Anschlüsse über jeweils eine Stromquelle I₀ mit einer zweiten Spannung V_{SS} verbunden sind. Die Stromquelle I₀ wird ebenfalls durch einen Transistor realisiert. So kann ein 2-Bit-Wandler aufgebaut werden.

Eine in ein Digitalsignal umzusetzende analoge Eingangsspannung Uᵢₙ wird den einzelnen Gate-Anschlüssen der MOSFETs M1₁, M1₂ und M1₃ zugeführt. Ausgangsspannungen Out₁, Out₂ und Out₃ werden an den Drain-Anschlüssen der MOSFETs M1₁, M1₂ und M1₃ abgegriffen und an eine nachfolgende zweite Stufe des Analog-Digital-Umsetzers (ADC) gekoppelt.

Die in **Fig. 1 (a)** gezeigte Eingangsstufe des ADC bildet eine parallele Anordnung von Invertern mit Stromquellenlast und mit in den Transistoren festgelegten unterschiedlichen Schwellenspannungen (Grautonlithographie-Komparator). Durch geeignete Variation der Schwellenspannung U_{T} sowohl der Eingangstransistoren M1ᵢ (i=1...m) als auch der Stromquellentransistoren kann die Schaltschwelle jedes der Inverter festgelegt bzw. verschoben werden.

**Fig. 4** zeigt den Verlauf der Ausgangsspannung eines Inverters nach **Fig. 1 (a)** als Funktion der Schwellenspannung U_{T} des Eingangstransistors, mit diskret dargestellten verschiedenen Schwellspannungen U_{T1}, U_{T2} aufgrund verschiedener Kanaldotierung.

**Fig. 1 (b)** zeigt einen 1-aus-n-Encoder als Beispiel für den 2-Bit-ADC aus Figur 1a. Den jeweiligen Gate-Anschlüssen einer Vielzahl von kaskadenförmig geschalteten N-Kanal MOSFETs M2₁, M2₂ und M2₃ (der Drain-Anschluß eines jeweiligen MOSFETs ist mit dem Gate-Anschluß des jeweiligen benachbarten MOSFETs verbunden) werden die Ausgangsspannungen Out₁, Out₂ und Out₃ zugeführt. Die Drain-Anschlüsse der einzelnen N-Kanal MOSFETs M2₁, M2₂ und M2₃ sind zur Signalpegelfestlegung jeweils mit entsprechenden Widerständen R_{Pu} verbunden, deren anderer Anschluß mit der ersten Spannung V_{DD} gekoppelt ist. An den mit den Widerständen R_{Pu} gekoppelten Drain-Anschlüssen der einzelnen N-Kanal MOSFETs M2₁, M2₂ und M2₃ werden Ausgangsspannungen A₁, A₂, A₃ abgegriffen und an eine nachfolgende dritte Stufe des Analog-Digital-Umsetzers gekoppelt.

Der 1-aus-n-Encoder bildet ein Auswahlmittel, welches in Abhängigkeit von den Eingangssignalen des Encoders Out₁, Out₂ und Out₃ genau eines der Ausgangssignale des Encoders A₁, A₂ und A₃ auf niedrigen Pegel (Low) setzt.

**Fig. 1 (c)** zeigt die dritte, eine Ausgangsstufe bildende Stufe des Analog-Digital-Umsetzers, die eine Vielzahl von in Parallelschaltung angeordneten P-Kanal MOSFETs M3₁, M3₂ und M3₃, deren Source-Anschlüsse mit der ersten Spannung V_{DD} und deren Drain-Anschlüsse über jeweils einen Widerstand R_{PD} mit der zweiten Spannung V_{SS} verbunden sind. Die Gate-Anschlüsse der MOSFETs M3₁, M3₂ und M3₃ sind mit den Ausgängen A₁, A₂ und A₃ der Encoderstufe gekoppelt.

An den Drain-Anschlüssen der MOSFETs M3₁, M3₂ und M3₃ wird in Abhängigkeit von dem in der Encoderstufe auf niedrigen Pegel gesetzten Ausgangssignal mittels durch Out_{bit} vereinfacht angedeuteten zwei parallelen Leitungen das aus der Umsetzung des analogen Eingangssignals resultierende Digitalsignal als 2-Bit-Wort gesetzt bzw. ausgegeben. Mehr Eingangstransistoren (2^{m}-1) führen zu einem m-Bit-Signal in Figur 1c.

**Fig. 3 (a) bis (d)** zeigen vereinfacht ein Verfahren, bei dem eine Photoresistschicht, beispielsweise ein Positiv-Resist, mittels Grauton-Photolithographie belichtet wird, und ist im Zusammenhang mit **Figur 5** zu sehen, die einen MOS-Transistor mit Kanal K zeigt.

Gemäß **Fig. 3 (a)** wird ein Grauwert auf der Photomaske 9 durch eine Vielzahl weißer oder schwarzer Bildpunkte dargestellt, deren Bildpunktdichte und/oder Bildpunktgröße variiert und so eine durch die Verteilung der Bildpunkte gegebene Rasterung der Photomaske erzeugt. Jeder Rasterungsbereich ist jeweils einem Kanal K eines Transistors zuzuordnen.

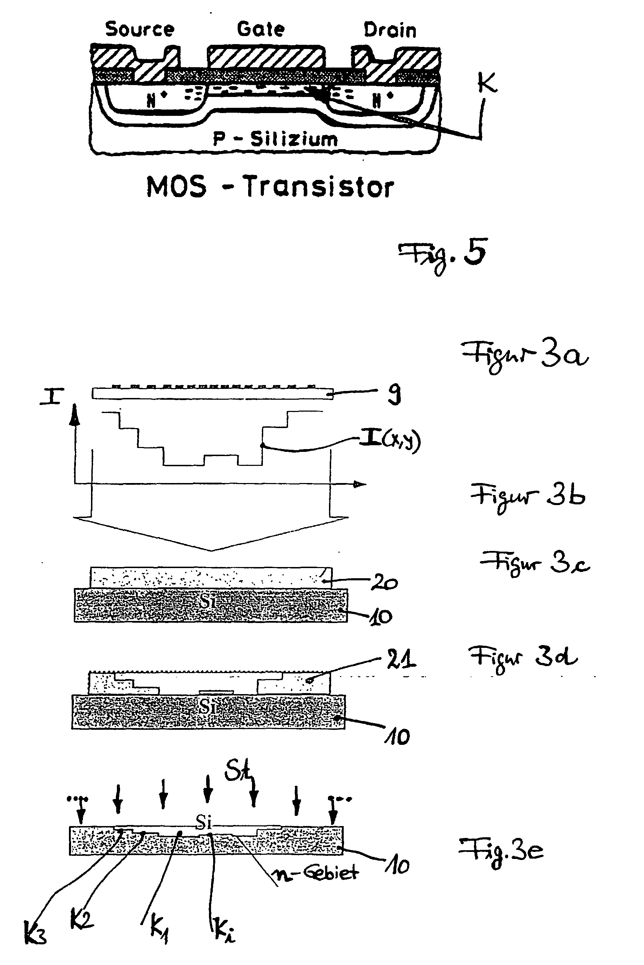

Durch die Photomaske hindurchtretendes Licht erhält eine Intensitätsverteilung entsprechend der Rasterung der Photomaske (Fig. 3 (b)) und belichtet den Photoresist(Fig. 3 (c)). Aus der nachfolgenden Resistentwicklung resultiert ein die Intensitätsverteilung widerspiegelndes lokal verteiltes Resistrelief auf der Oberfläche des Halbleitersubstrats (Fig. 3 (d)), welches in dem sich anschließenden Implantationsschritt die Eindringtiefe der implantierten N-Ionen in das Si-Halbleitersubstrat zur Dotierung des jeweiligen Kanals K bestimmt (vgl. Fig. 3 (e)).

Durch die Anwendung der Grauton-Photolithographie in Verbindung mit der nachfolgenden Implantation von Dotierungsstoffen in Halbleitersubstrate können somit durch die bereichsweise Variation und Optimierung der Implantations- bzw. Dotierungsintensität mikroelektronische Bauelemente hergestellt werden, die im Vergleich zu auf herkömmlicher Art und Weise hergestellten Bauelementen deutlich veränderte Eigenschaften aufweisen, namentlich mehrere durch Dotierung gesteuerte Schwellspannungen zur Bildung der AD-Eingangsstufe.

Insbesondere erlaubt die Grautonlithographie die Herstellung eines parallelen, eine Transistor-Schwellenspannungskaskade aufweisenden Analog-Digital-Umsetzers in einer sehr kompakten Schaltungsanordnung. Untersuchungen haben hierbei ergeben, daß die Schaltungsanordnung eines solchen Analog-Digital-Umsetzers nur etwa 20% der Fläche der Schaltungsanordnug eines herkömmlichen parallelen Analog-Digital-Umsetzers erfordert.

Diese drastische Reduzierung der Schaltungsfläche führt zur vorteilhaften Anwendbarkeit des beschriebenen Flash-Analog-Digital-Umsetzers in Bereichen, in welchen eine große Zahl von Informationen gleichzeitig verarbeitet werden muß, d.h. typisch in der sehr schnellen Wandlung und Aufbereitung von Detektorarrays oder in komplexen und intelligenten Detektorsystemen wie z.B. einem künstlichen Auge oder einer künstlichen Retina.

**Die Figur 4** sollte in Verbindung mit **der Figur 5** betrachtet werden. Der MOS-Transistor gemäß Figur 5 hat einen Kanalbereich K zwischen dem Drain- und dem Source-Anschluß. Der Kanal wird in seinem Durchlaßwiderstand gesteuert von der Spannung am Gate, gegenüber dem D-Anschluß oder gegenüber dem S-Anschluß, je nach Kanaldotierung (N-Kanal oder P-Kanal). An den Kennlinien in Figur 4 ist ersichtlich, daß eine unterschiedliche Schwellenspannung eines Transistors einen unterschiedlichen Beginn des Leitens des Kanales und des Fließens von Strom zwischen Drain und Source verursacht. Mit größer werdender Schwellenspannung, die durch unterschiedliche Kanaldotierung (Variation der Implantationsdosen des Kanales) entsteht, wird auch der lineare Sättigungsabschnitt der Kennlinie nach rechts und unten verschoben. Zusammen mit einer Stromquelle gemäß Figur 1 (a) oder gemäß der noch zu erläuternden Figur 2 (a) als Lastwiderstand arbeiten die MOS-Transistoren mit unterschiedlichen Schwellspannungen gemäß Figur 4 als Komparatoren, wobei der Strom der Stromquelle so bemessen ist, daß hinter dem Übergangsbereich zum Sättigungsbereich sich der Arbeitspunkt ergibt (im Sättigungsbereich). Die Schaltungen gemäß Figur 1 (a) und gemäß Figur 2 (a) arbeiten so als Komparatoren, wobei die Komparator-Schwelle durch die Schwellenspannung des MOS-Transistors festgelegt ist.

Die Schaltungen gemäß **Figur 2 (a) bis 2 (c)** sind vergleichbar von ihrer Funktion mit den Schaltungen gemäß **Figur 1 (a) bis 1 (c)**. Es sind hier nur andere Typen von MOS-Transistoren verwendet, mit Ausnahme der jeweiligen Teilfigur (a), die in jedem Fall ein P-Kanal-MOSFET verwendet.

Die Ausgangssignale der jeweiligen Teilfigur (a) sind so gestaffelt, daß diejenigen Ausgänge, die mit Eingangstransistoren M1ᵢ gekoppelt sind, die eine Schwellenspannung oberhalb der Differenz zwischen VDD und Uᵢₙ haben, durch deren Nichtleiten auf das Potential von VSS gesetzt sind. Alle anderen Ausgänge sind auf das Potential VDD gesetzt und von dieser Ausgangssignal-Konfiguration wandelt die Schaltung gemäß der Teilfigur (b) in den Figuren 1 und 2 auf nur einen Ausgang mit hohem oder niedrigem Digitalwert um, wobei alle anderen Ausgänge der jeweiligen Teilfigur (b) auf dem jeweils anderen Potential liegen. Die Schaltung in Figur 2 (b) ist dabei mit P-Kanal-Transistoren aufgebaut, während die Figur 1 (b) mit N-Kanal-Transistoren aufgebaut war. Es ergibt sich nur der Unterschied, daß die Widerstände R_{PU} gemäß Figur 1 (b) in Widerstände R_{PD} zum anderen Potential VSS geschaltet werden.

Die Schaltung gemäß Figur 2 (c) ist so konzipiert, daß der eine logisch aktive Pegel der drei beispielhaft gewählten Ausgangssignale von Figur 2 (b) dazu führt, daß das entsprechende binäre Wort an den zwei Ausgangsanschlüssen des Zwei-Bit-Wandlers entsteht. Die Zuordnungen der Ausgangssignale der Figur 2 (b) zu den Gate-Anschlüssen der Figur 2 (c) sind durch Benennung klar ersichtlich. Wenn Mehrbit-Ausgangssignale verwendet werden, entstehen entsprechend mehr parallel geschaltete Transistoren M3₁, M3₂ etc., die so mit ihren Gate-Anschlüssen mit den Ausgangsanschlüssen der Figur 2 (b) zusammengeschaltet sind, daß die Anzahl der diskreten Digitalstufen der Figur 2 (b) auf ein binäres Wort umgesetzt werden. Mit anderen Worten kann der Fachmann aus der Überlegung, daß für bestimmte diskrete Stufen in der gesamten Auflösung des A/D-Wandlers bestimmte Bits zwischen dem höchstwertigsten und dem niederwertigsten, einschließlich dieser beiden Bits nicht aktiv sind, so daß die nicht aktiven Bits durch einen entsprechenden Transistor in der Figur 2 (c) auf Null zu schalten sind, die jeweilige Gesamtschaltung leicht herleiten.

Ein Beispiel mag das verdeutlichen. Bei einer Auflösung von 32 diskreten Stufen (2⁵), also fünf Bit am Ausgang der Figur 2 (c) sind alle diskreten Ausgänge der Figur 2 (b), die unterhalb der diskreten Stufe 16 liegen, also alle binären Wertigkeiten 0 bis 15 so heranzuziehen, daß alle diese Anschlüsse mit jeweils einem Transistor zu verbinden sind, der das höchstwertigste Bit der beispielsweise angenommenen 32 Bit-Wandlung auf Null schaltet. Das MSB-Ausgangsbit (Wertigkeit 2⁴=16) der Figur 2 (c) hätte also 15 parallel geschaltete Transistoren.

Zur Verdeutlichung der **Figur 3** ist noch anzumerken, daß sie die Implantation bezüglich der **Figuren 2 (a) und 1 (a)** zu den dortigen Transistoren M1ᵢ betrifft. Die in ihrer Grauschattierung mit einer Durchlässigkeit oberhalb von 0% und unterhalb von 100% versehene Photomaske 9 erzeugt das Intensitätsprofil I(x,y), wobei x und y die Ebene des Substrats 10 aus Silizium definieren. Auf diesem Substrat 10 ist eine Resist-Schicht 20 aufgebracht, die mit dem Intensitätsprofil I(x,y) belichtet wird. Es entsteht nach der Entwicklung des Resists 20 eine lokal veränderte Resist-Resthöhe in dem profilierten Resist 21, wobei jede Resthöhe einem Kanal Kᵢ eines zu bildenden MOS-Transistors der Eingangsstufe von Figur 1 (a) oder Figur 2 (a) zugewiesen ist. Das unmittelbare Nebeneinanderliegen der Stufen des Resistreliefs 21 dient der Verdeutlichung der unterschiedlichen Höhen, die bei Beabstandung und zugeordnet zu einem jeweiligen Transistor nicht mehr so deutlich zu erkennen gewesen wären.

Die mit gleichmäßiger Implantationsstrahlung ausgeführte Dotierung der jeweiligen Kanäle K₁,K₂,K₃ ... Kᵢ führt zu einer unterschiedlichen Implantationsdosis in den verschiedenen Kanälen und damit zu einer unterschiedlichen Schwellenspannung U_{Ti}, womit das Intensitätsprofil gemäß Figur 3 (b) dafür sorgt, daß eine Variation der Schwellenspannung aller Transistoren der Eingangsstufe mit einem Belichtungsschritt und einem Implantationsschritt möglich ist. Die Figur 3 (e) kennzeichnet demnach nicht den Abtrag des Substrates 10 an den unterschiedlich maskierten "Stufen" Kᵢ, sondern sie kennzeichnet die unterschiedliche Dotierungsintensität, repräsentiert durch eine unterschiedlich tiefe Eindringung der Implantationsstrahlung in das Substrat 10. Diese Darstellung wurde zu Veranschaulichungsgründen gewählt, sie beschreibt nicht, daß die Kanäle der zu bildenden MOS-Transistoren unterschiedlich tief, unterschiedlich breit oder geometrisch unterschiedlich ausgebildet sind, sie sind vielmehr nur unterschiedlich in ihrer Implantationsdosis zur Ausbildung unterschiedlicher Schwellenspannungen gestaltet.

## Patentansprüche

1. **Analog-Digital-Umsetzer** zum parallelen oder sofortigen Umsetzen eines analogen Eingangssignals (Uᵢₙ) in ein digitales Ausgangssignal, mit
- einer **ersten Stufe** mit mehreren ersten Transistoren (M1₁,M1₂,M1₃ ...M1ᵢ), deren Steueranschlüssen ein analoges Eingangssignal (Uᵢₙ) zuführbar ist, wobei in Abhängigkeit von der Größe des analogen Eingangssignals am Ausgang (Out₁, Out₂ ...) der ersten Stufe ein erstes digitales Ausgangssignal abgebbar ist;
- einer **zweiten Stufe** mit mehreren zweiten Transistoren (M2₁,M2₂,M2₃ ...M2ᵢ), um an Steueranschlüssen das digitale Ausgangssignal der ersten Stufe als erstes digitales Eingangssignal zu empfangen, wobei in Abhängigkeit von der Größe dieses ersten Eingangssignals an einem Ausgang (A₁,A₂,A₃ ...Aᵢ) der zweiten Stufe ein zweites digitales Ausgangssignal abgebbar ist;
- einer **dritten Stufe** mit mehreren dritten Transistoren (M3₁,M3₂,M3₃ ... M3ᵢ), um an Steueranschlüssen das zweite digitale Ausgangssignal als zweites digitales Eingangssignal zu empfangen, wobei in Abhängigkeit von der Größe dieses zweiten Eingangssignals am Ausgang (Out_{bit}) der dritten Stufe ein dem analogen Eingangssignal entsprechendes digitales Ausgangssignal gebildet und abgebar ist;
wobei alle Transistoren der ersten Stufe als MOS-Feldeffekttransistoren mit einer jeweils vorbestimmten, unterschiedlichen Schwellenspannung (U_{T}) ausgebildet sind; **dadurch gekennzeichnet, daß** die Schwellenspannungen (U_{T}) bei der Herstellung im wesentlichen gleichzeitig durch eine Grautonlithographie-Photomaske vorgegeben worden sind, wobei Dotierungen der Kanäle der MOS-Feldeffekttransistoren nicht gleich sind bzw. zwei oder mehr Transistoren der ersten Stufe unterschiedliche Dotierungsintensitäten in ihren Kanälen haben.

2. Analog-Digital-Umsetzer nach Anspruch 1, wobei ein Implantationsschritt zur Einstellung der Schwellenspannungen (U_{T}) von in dem Halbleitersubstrat angeordneten MOS-Feldeffekttransistoren die Oberflächenkonzentrationen ihrer Kanalbereiche in Übereinstimmung mit einer jeweiligen örtlich definierten Transparenz der Grautonlithographie-Photomaske erzeugt hat.

3. Analog-Digital-Umsetzer nach Anspruch 1 oder 2, **dadurch gekennzeichnet, daß** die ersten Transistoren (M1ᵢ) P-Kanal Enhancement Mode MOS-Feldeffekttransistoren, daß die zweiten Transistoren (M2ᵢ) N-Kanal Enhancement Mode MOS-Feldeffekttransistoren, und daß die dritten Transistoren (M3ᵢ) P-Kanal Enhancement Mode Feldeffekttransistoren sind, oder vice versa hinsichtlich der zweiten und dritten Stufe.

4. Analog-Digital-Umsetzer nach einem der Ansprüche 1 bis 3, **dadurch gekennzeichnet, daß** die ersten Transistoren an ihren Source-Anschlüssen mit einer ersten Spannung (V_{DD}) und an ihren Drain-Anschlüssen mit jeweils einem Ausgangsanschluß und jeweils einer Stromquelle (I₀) zu einer zweiten Spannung (V_{SS}) verbunden sind, wobei das analoge Eingangssignal (Uᵢₙ) den Gate-Anschlüssen der ersten Transistoren zuführbar ist.

5. Analog-Digital-Umsetzer nach Anspruch 4, **dadurch gekennzeichnet, daß** die jeweilige Stromquelle (I₀) einen Transistor mit vorbestimmter Schwellenspannung umfaßt, die auch mittels im Durchlaßverhalten gesteuert veränderter Maske im selben Belichtungs- und Implantationsschritt gebildet wurde, wie die Kanäle der ersten Transistoren (M1ᵢ) der ersten Stufe.

6. Analog-Digital-Umsetzer nach Anspruch 5, **dadurch gekennzeichnet, daß** ein jeweiliger erster Transistor und die zugehörige Stromquelle einen Inverter bilden, dessen erste Schaltschwelle (U_{T}) in Abhängigkeit von der Schwellenspannung des ersten Transistors und/oder des zugehörigen Stromquellentransistors festgelegt ist, wobei weitere erste Transistoren (M1ᵢ) andere Schwellen-Spannungen (U_{Ti}) als der erste Transistor aufweisen.

7. Analog-Digital-Umsetzer nach einem der Ansprüche 1 bis 6, wobei die erste Stufe die Vielzahl von parallel angeordneten ersten Transistoren (M1₁, M1₂, M1₃) umfaßt, die zweite Stufe die Vielzahl von in Kaskadenschaltung angeordneten zweiten Transistoren (M2₁, M2₂, M2₃) umfaßt, und die dritte Stufe die Vielzahl von parallel angeordneten dritten Transistoren (M3₁, M3₂, M3₃) umfaßt.

8. Analog-Digital-Umsetzer nach Anspruch 1 oder 7, **dadurch gekennzeichnet, daß** die zweite Stufe als 1-aus-n-Encoder ausgebildet, um in Abhängigkeit von den Pegeln einer Vielzahl von zugeführten ersten digitalen Bits des digitalen Eingangssignals genau einen Ausgangsanschluß (A) auf einen hohen oder niedrigen Pegel zu schalten.

9. Analog-Digital-Umsetzer nach Anspruch 1, 7 oder 8, **dadurch gekennzeichnet, daß** in der dritten Stufe zur Ausgabe eines mit mehreren Bits versehenen binär codierten digitalen Ausgangssignals des Analog-Digital-Umsetzers eine Vielzahl paralleler Ausgangsleitungen (Out_{bit}) in Abhängigkeit von dem genau einen Ausgangs-Anschluß auf hohen bzw. niedrigen Pegel schaltbar sind.

10. **Verfahren** zur Herstellung eines Analog-Digital-Umsetzers zum parallelen Umsetzen eines analogen Eingangssignals in ein digitales Ausgangssignal, **gekennzeichnet durch** die Schritte
(a) Aufbringen einer Photoresistschicht (20) auf die Oberfläche eines Halbleitersubstrats (10);
(b) Belichten der Photoresistschicht mit einem Strahlungs-Intensitätsprofil entsprechend einer vorbestimmten Bildpunkt-Rasterung einer optischen Grautonlithographie-Photomaske (9) jeweils an den Orten der Kanäle (Kᵢ) der zu bildenden Transistoren (M1ᵢ);
(c) Erzeugen eines lokal auf die Orte der jeweiligen Kanäle (Kᵢ) der zu bildenden Transistoren (M1ᵢ) ausgerichteten Resistreliefs (21) in der Photoresistschicht (20) **durch** Entwickeln und/oder Ätzen der belichteten Photoresistschicht;
(d) lokal unterschiedliches Implantieren von Dotierungsstoffen **durch** das Resistrelief hindurch in die Kanalbereiche des Halbleitersubstrats (10), trotz gleichmäßiger Implantatstrahlung auf die Resistschicht (21), so daß die Dotieringen für eine Ausbildung von Schwellenspannungen (U_{T}) der zu bilden den Transistoren im wesentlichen gleichzeitig **durch** die Grautonlithographie-Photomaske vorgegeben werden.

11. Verfahren nach Anspruch 10, **dadurch gekennzeichnet, daß** als Grautonlithographie-Photomaske eine Maske verwendet wird, deren Bildpunkt-Rasterung eine Transparenz für die Einstellung der lokalen Durchlässigkeit zwischen 0% und 100% aufweist (unter 100%, über 0%).

12. Verfahren nach Anspruch 11, **dadurch gekennzeichnet, daß** der Implantationsschritt gemäß (d) zur Einstellung der Schwellenspannung (U_{T}) von in dem Halbleitersubstrat angeordneten MOS-Feldeffekttransistoren die Oberflächenkonzentrationen ihrer Kanalbereiche in Übereinstimmung mit einer jeweiligen örtlich definierten Transparenz der Grautonlithographie-Photomaske erzeugt.

## Claims

1. Analog-digital converter for parallel or immediate conversion of an analog input signal (Uᵢₙ) into a digital output signal, having
- a first stage with several first transistors (M1₁, M1₂, M1₃ ... M1ᵢ), to the control connections of which an analog input signal (Uᵢₙ) can be supplied, wherein a first digital output signal can be emitted as a function of the size of the analog input signal at the output (Out₁, Out₂ ...) of the first stage;
- a second stage with several second transistors (M2₁, M2₂, M2₃ ...M2ᵢ), in order to receive at control connections the digital output signal of the first stage as first digital input signal, wherein a second digital output signal can be emitted as a function of the size of this first input signal at an output (A₁, A₂, A₃, ...Aᵢ) of the second stage;
- a third stage with several third transistors (M3₁, M3₂, M3₃ ...M3ᵢ), in order to receive at control connections the second digital output signal as second digital input signal, wherein a digital output signal corresponding to the analog input signal is formed and can be emitted as a function of the size of this second input signal at the output (Out_{bit}) of the third stage;
wherein all transistors of the first stage are designed as MOS field effect transistors having an in each case predetermined, different threshold voltage (U_{T}); **characterised in that** the threshold voltages (U_{T}) have been preset essentially at the same time by a grey-tone lithography photomask during production, wherein doping of the channels of the MOS field effect transistors is not the same or two or more transistors of the first stage have different doping intensities in their channels.

2. Analog-digital converter according to claim 1, wherein an implantation step for adjusting the threshold voltages (U_{T}) of MOS field effect transistors arranged in the semiconductor substrate has produced the surface concentrations of their channel regions in agreement with a particular locally defined transparency of the grey-tone lithography photomask.

3. Analog-digital converter according to claim 1 or 2, **characterised in that** the first transistors (M1ᵢ) are P-channel Enhancement Mode MOS field effect transistors, **in that** the second transistors (M2ᵢ) are N-channel Enhancement Mode MOS field effect transistors, and **in that** the third transistors (M3ᵢ) are P-channel Enhancement Mode field effect transistors, or vice versa with respect to the second and third stage.

4. Analog-digital converter according to one of claims 1 to 3, **characterised in that** the first transistors are connected at their source connections to a first voltage (V_{DD}) and at their drain connections to in each case an output connection and in each case a current source (I₀) to a second voltage (V_{SS}), wherein the analog input signal (Uᵢₙ) can be supplied to the gate connections of the first transistors.

5. Analog-digital converter according to claim 4, **characterised in that** the particular current source (I₀) comprises a transistor with predetermined threshold voltage, which has also been formed in the same exposure and implantation step by means of a mask changed in transmission behaviour in controlled manner, like the channels of the first transistors (M1ᵢ) of the first stage.

6. Analog-digital converter according to claim 5, **characterised in that** a particular first transistor and the associated current source form an inverter, the first switch threshold (U_{T}) of which is fixed as a function of the threshold voltage of the first transistor and/or of the associated current source transistor, wherein further first transistors (M1ᵢ) have different threshold voltages (U_{Ti}) than the first transistor.

7. Analog-digital converter according to one of claims 1 to 6, wherein the first stage comprises the plurality of first transistors (M1₁, M1₂, M1₃) arranged in parallel, the second stage comprises the plurality of second transistors (M2₁, M2₂, M2₃) arranged in series connection, and the third stage comprises the plurality of third transistors (M3₁, M3₂, M3₃) arranged in parallel.

8. Analog-digital converter according to claim 1 or 7, **characterised in that** the second stage designed as 1-out-n-encoder in order to switch precisely one output connection (A) to a high or low level as a function of the levels of a plurality of supplied first digital bits of the digital input signal.

9. Analog-digital converter according to claim 1, 7 or 8, **characterised in that** in the third stage, a plurality of parallel output cables (Out_{bit}) can be switched to high or low level as a function of the precisely one output connection to emit a binary coded digital output signal of the analog-digital converter provided with several bits.

10. Process for producing an analog-digital converter for parallel conversion of an analog input signal into a digital output signal, **characterised by** the steps
(a) applying a photoresist layer (20) to the surface of a semiconductor substrate (10);
(b) exposure of the photoresist layer with a radiation intensity profile corresponding to a predetermined picture element screening of an optical grey-tone lithography photomask (9) in each case at the sites of channels (Kᵢ) of the transistors (M1ᵢ) to be formed;
(c) production of a resist relief (21) aligned locally to the sites of the particular channels (Kᵢ) of the transistors (M1ᵢ) to be formed in the photoresist layer (20) by developing and/or etching the exposed photoresist layer;
(d) locally different implantation of doping materials through the resist relief into the channel regions of the semiconductor substrate (10), in spite of uniform implant radiation onto the resist layer (21), so that the doping for forming threshold voltages (U_{T}) of the transistors to be formed is preset essentially at the same time by the grey-tone lithography photomask.

11. Process according to claim 10, **characterised in that** a mask is used as the grey-tone lithography photomask, the picture element scanning of which has a transparency for adjusting the local transmittance between 0% and 100% (below 100%, above 0%).

12. Process according to claim 11, **characterised in that** the implantation step according to (d) for adjusting the threshold voltage (U_{T}) of MOS field effect transistors arranged in the semiconductor substrate produces the surface concentrations of their channel regions in agreement with a particular locally defined transparency of the grey-tone lithography photomask.

## Revendications

1. Convertisseur analogique-numérique pour la conversion parallèle ou immédiate d'un signal d'entrée analogique (Uᵢₙ) en un signal de sortie numérique,
- avec un premier étage comportant plusieurs premiers transistors (M1₁, M1₂, M1₃, ..., M1ᵢ) aux bornes de commande desquels peut être envoyé un signal d'entrée analogique (Uᵢₙ), un premier signal de sortie numérique pouvant être fourni à la sortie (Out₁, Out₂, ...) du premier étage en fonction de la grandeur du signal d'entrée analogique ;
- avec un deuxième étage comportant plusieurs deuxièmes transistors (M2₁, M2₂, M2₃, ..., M2ᵢ) pour recevoir à des bornes de commande le signal de sortie numérique du premier étage en tant que premier signal d'entrée numérique, un deuxième signal de sortie numérique pouvant être fourni à une sortie (A₁, A₂, A₃, ..., Aᵢ) du deuxième étage en fonction de la grandeur de ce premier signal d'entrée ;
- avec un troisième étage comportant plusieurs troisièmes transistors (M3₁, M3₂, M3₃, ..., M3ᵢ) pour recevoir à des bornes de commande le deuxième signal de sortie numérique en tant que deuxième signal d'entrée numérique, un signal de sortie numérique correspondant au signal d'entrée analogique étant formé et pouvant être fourni à la sortie (Out_{bit}) du troisième étage en fonction de la grandeur de ce deuxième signal d'entrée ;
tous les transistors du premier étage étant conçus comme des transistors à effet de champ MOS avec une tension de seuil (U_{T}) différente et prédéterminée à chaque fois ;
**caractérisé en ce que** les tensions de seuil (U_{T}) ont été prédéterminées globalement simultanément lors de la fabrication par un photomasque de lithographie à teintes de gris, des dopages des canaux des transistors à effet de champ MOS n'étant pas égaux c'est-à-dire deux ou plusieurs transistors du premier étage ayant des intensités de dopage différentes dans leurs canaux.

2. Convertisseur analogique-numérique selon la revendication 1, dans lequel une étape d'implantation pour le réglage des tensions de seuil (U_{T}) de transistors à effet de champ MOS placés dans le substrat semi-conducteur a produit les concentrations de surface de leurs zones de canal en fonction d'une transparence respective, définie localement, du photomasque de lithographie à teintes de gris.

3. Convertisseur analogique-numérique selon la revendication 1 ou 2, **caractérisé par le fait que** les premiers transistors (M1ᵢ) sont des transistors à effet de champ MOS à mode d'enrichissement de canal P, que les deuxièmes transistors (M2ᵢ) sont des transistors à effet de champ MOS à mode d'enrichissement de canal N, que les troisièmes transistors (M3ᵢ) sont des transistors à effet de champ à mode d'enrichissement de canal P, ou vice-versa pour ce qui est du deuxième et du troisième étage.

4. Convertisseur analogique-numérique selon l'une des revendications 1 à 3, **caractérisé par le fait que** les premiers transistors sont reliés par leurs bornes de source à une première tension (V_{DD}) et par leurs bornes de drain à chaque fois à une borne de sortie et à chaque fois à une source de courant (I₀) pour une deuxième tension (V_{SS}), le signal d'entrée analogique (Uᵢₙ) pouvant être envoyé aux bornes de grille des premiers transistors.

5. Convertisseur analogique-numérique selon la revendication 4, **caractérisé par le fait que** la source de courant (I₀) respective comprend un transistor avec une tension de seuil prédéterminée qui a aussi été formée au moyen de masques, dont la transparence est modifiée de façon commandée, dans la même étape d'exposition et d'implantation que les canaux des premiers transistors (M1ᵢ) du premier étage.

6. Convertisseur analogique-numérique selon la revendication 5, **caractérisé par le fait qu'**un premier transistor respectif et la source de courant associée forment un inverseur dont le premier seuil de commutation (U_{T}) est fixé en fonction de la tension de seuil du premier transistor et/ou du transistor de source de courant associé, d'autres premiers transistors (M1ᵢ) ayant d'autres tensions de seuil (U_{Ti}) que le premier transistor.

7. Convertisseur analogique-numérique selon l'une des revendications 1 à 6, dans lequel le premier étage comprend la multiplicité de premiers transistors (M1₁, M1₂, M1₃) branchés en parallèle, le deuxième étage comprend la multiplicité de deuxièmes transistors (M2₁, M2₂, M2₃) branchés en cascade et le troisième étage comprend la multiplicité de troisièmes transistors (M3₁, M3₂, M3₃) branchés en parallèle.

8. Convertisseur analogique-numérique selon la revendication 1 ou 7, **caractérisé par le fait que** le deuxième étage est conçu comme un codeur 1 parmi n pour commuter exactement une borne de sortie (A) sur un niveau haut ou bas en fonction des niveaux d'une pluralité de premiers bits numériques envoyés du signal d'entrée numérique.

9. Convertisseur analogique-numérique selon la revendication 1, 7 ou 8, **caractérisé par le fait que**, dans le troisième étage, pour fournir un signal de sortie numérique, codé en binaire et muni de plusieurs bits, du convertisseur analogique-numérique, une multiplicité de lignes de sortie parallèles (Out_{bit}) peuvent être commutées sur un niveau haut ou bas en fonction de la seule borne de sortie.

10. Procédé pour la fabrication d'un convertisseur analogique-numérique pour la conversion parallèle d'un signal d'entrée analogique en un signal de sortie numérique, **caractérisé par** les étapes suivantes :
(a) application d'une couche de photorésist (20) sur la surface d'un substrat semi-conducteur (10) ;
(b) exposition de la couche de photorésist avec un profil d'intensité de rayonnement selon une trame prédéterminée de points d'image d'un photomasque optique de lithographie à teintes de gris (9) à chaque fois aux emplacements des canaux (Kᵢ) des transistors à former (M1ᵢ) ;
(c) production d'un relief de résiste (21), dirigé localement vers les emplacements des canaux respectifs (Kᵢ) des transistors à former (M1ᵢ), dans la couche de photorésist (20) par développement et/ou gravure de la couche de photorésist exposée ;
(d) implantation localement différente de substances de dopage à travers le relief de résiste dans les zones de canal du substrat semi-conducteur (10), malgré un rayonnement d'implantation régulier sur la couche de résiste (21), de telle sorte que les dopages pour une conception de tensions de seuil (U_{T}) des transistors à former sont prédéterminés globalement simultanément par le photomasque de lithographie à teintes de gris.

11. Procédé selon la revendication 10, **caractérisé par le fait qu'**on utilise comme photomasque de lithographie à teintes de gris un masque dont la trame de points d'image a une transparence pour le réglage de la transparence locale entre 0 % et 100 % (inférieure à 100 %, supérieure à 0 %).

12. Procédé selon la revendication 11, **caractérisé par le fait que** l'étape d'implantation selon (d) pour le réglage de la tension de seuil (U_{T}) de transistors à effet de champ MOS placés dans le substrat semi-conducteur produit les concentrations de surface de leurs zones de canal en fonction d'une transparence respective, définie localement, du photomasque de lithographie à teintes de gris.
